(19) Europäisches Patentamt
European Patent Office
Office européen des brevets

(11) EP 4 717 802 A1

(12) EUROPEAN PATENT APPLICATION

(43) Date of publication:
01.04.2026 Bulletin 2026/14

(21) Application number: 25204567.9

(22) Date of filing: 25.09.2025

(51) International Patent Classification (IPC):
*C30B 25/16* (2006.01)     *C30B 29/36* (2006.01)

(52) Cooperative Patent Classification (CPC):
C30B 29/36; C30B 25/165

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 30.09.2024 JP 2024170794

(71) Applicant: Resonac Corporation
Tokyo 105-7325 (JP)

(72) Inventor: MIYASAKA, Akira
Tokyo 105-7325 (JP)

(74) Representative: Strehl & Partner mbB
Maximilianstrasse 54
80538 München (DE)

(54) SIC EPITAXIAL WAFER, METHOD FOR MANUFACTURING SIC EPITAXIAL WAFER, AND SIC DEVICE

(57) What is provided is a SiC epitaxial wafer and a SiC device having a SiC epitaxial layer in which a carrier lifetime can be estimated and a variation in a density of a $Z_{1/2}$ center in a depth direction is curbed. The SiC epitaxial wafer includes a substrate and a SiC epitaxial layer formed on a first surface of the substrate, wherein a uniformity of the density of the $Z_{1/2}$ centers in the depth direction in the SiC epitaxial layer is less than 0.5 (%/$\mu$m).

FIG. 1

EP 4 717 802 A1

**Description**

BACKGROUND OF THE INVENTION

Field of the Invention

The present invention relates to a SiC epitaxial wafer, a method for manufacturing a SiC epitaxial wafer, and a SiC device.

Description of Related Art

Silicon carbide (SiC) has a breakdown field strength that is one order of magnitude larger than that of silicon (Si) and a band gap that is three times larger than that of silicon (Si). Therefore, silicon carbide (SiC) is expected to be applied to power devices, high frequency devices, high temperature operating devices, and the like. For this reason, in recent years, SiC epitaxial wafers have come to be used in the above-described semiconductor devices.
SiC epitaxial wafers are obtained by forming a SiC epitaxial layer on a SiC substrate using a chemical vapor deposition (CVD) method. The SiC epitaxial layer becomes an active region in the SiC device.
Defects in the SiC epitaxial layer of the SiC epitaxial wafer affect characteristics of SiC devices. For example, Patent Document 1 describes that a $Z_{1/2}$ center in the SiC epitaxial layer affects a carrier lifetime.
Non-Patent Document 1 describes that a surface treatment is performed after a SiC epitaxial layer is formed in order to reduce the number of $Z_{1/2}$ centers.

[Patent Documents]

[Patent Document 1] Japanese Unexamined Patent Application, First Publication No. 2016-132604

[Non-Patent Documents]

[Non-Patent Document 1] J. Appl. Phys. 113. 083714 (2013)

SUMMARY OF THE INVENTION

As described above, since the $Z_{1/2}$ center affects the characteristics of SiC devices, it is preferable to be able to control a density and distribution of the $Z_{1/2}$ center in the SiC epitaxial layer. However, it is difficult to control the density of the $Z_{1/2}$ centers during a process of forming the epitaxial layer.
In Patent Document 1, ten arbitrary regions in the SiC epitaxial layer are measured by a deep level transient spectroscopy (DLTS) method, and it is preferable that an average value of the density of the $Z_{1/2}$ centers in the ten regions be $5\times10^{11}$ cm$^{-3}$ or less. Patent Document 1 discloses that chemical mechanical polishing (CMP) is performed on a main surface of the SiC epitaxial wafer after the formation of an epitaxial layer. It is believed that such post-treatment after the formation of the epitaxial layer can reduce the density of the $Z_{1/2}$ centers in the SiC epitaxial wafer. In Patent Document 1, criteria for selecting the 10 measurement regions for measuring the density of the $Z_{1/2}$ centers are not explicitly stated, and it is unclear which regions have an average value of the density of the $Z_{1/2}$ centers that is preferably within the above numerical range.
Non-Patent Document 1 discloses that the density of the $Z_{1/2}$ centers in the SiC epitaxial wafer which has a SiC epitaxial layer having a thickness of 100 μm and formed by the CVD method was $1.5\times10^{12}$ to $3.0\times10^{12}$ (cm$^{-3}$). Non-Patent Document 1 shows measurement results of the density of the $Z_{1/2}$ centers at positions with different depth components in a measurement region having the same in-plane direction. According to the measurement results, the density of the $Z_{1/2}$ centers in the SiC epitaxial layer was $2.0\times10^{12}$ cm$^{-3}$, which was the highest, at an outermost surface, and was $1.2\times10^{12}$ cm$^{-3}$, which was the lowest, at a position having a depth of 100 μm, and a variation in the density of the $Z_{1/2}$ centers in a depth direction was 0.66% per 1 μm (0.66 (%/μm)). Furthermore, the density of the $Z_{1/2}$ centers in the SiC epitaxial layer was reduced by a post-treatment in which carbon ion implantation and heat treatment are performed after epitaxial growth, and was below a detection limit ($1.0\times10^{11}$ cm$^{-3}$) at any depth position after the post-treatment.
When the density of the $Z_{1/2}$ centers in the SiC epitaxial layer is below the detection limit in this way, it is difficult to estimate the carrier lifetime, and the variation in the density of the $Z_{1/2}$ centers in the depth direction is unknown.
The present invention has been made in view of the above circumstances, and an object thereof is to provide a SiC epitaxial wafer, a method for manufacturing a SiC epitaxial wafer, and a SiC device in which a carrier lifetime can be estimated and a variation in a density of a $Z_{1/2}$ center in a depth direction of the SiC epitaxial layer is curbed.
In order to solve the above problems, the present invention provides the following means.

(1) A SiC epitaxial wafer according to one embodiment of the present invention includes a SiC substrate, and a SiC epitaxial layer formed on a first surface of the SiC substrate, wherein a uniformity of a density of a $Z_{1/2}$ center in a depth direction in the SiC epitaxial layer is less than 0.5 (%/$\mu$m).

(2) A diameter of the SiC epitaxial wafer of (1) may be 149 mm or more.

(3) A diameter of the SiC epitaxial wafer of (1) may be 199 mm or more.

(4) In the SiC epitaxial wafer of (1) to (3), when central coordinates in a plan view are (0,0) and a radius is R, the density of the $Z_{1/2}$ centers at 10 locations on a surface in the vicinity of an outermost surface in the depth direction and on a surface in the vicinity of the first surface at coordinates (0,0), ($\pm$R/2,0) and (0,$\pm$R/2) may be $1 \times 10^{11}$ cm$^{-3}$ or more and $1.0 \times 10^{13}$ cm$^{-3}$ or less.

(5) In the SiC epitaxial wafer of (1) to (4), when central coordinates in a plan view are (0,0) and a radius is R, a maximum value Max and a minimum value Min of the density of the $Z_{1/2}$ centers at 10 locations on the surface in the vicinity of the outermost surface in the depth direction and on the surface in the vicinity of the first surface at coordinates (0, 0), ($\pm$R/2, 0), and (0, $\pm$R/2) may satisfy Equation (1).

$$[\{(\text{Max}-\text{Min})/\text{mean}\} \times 100] < (5 + 0.5 \times D) \ldots (1)$$

(D: distance ($\mu$m) between the surface in the vicinity of the outermost surface and the surface in the vicinity of the first surface,

mean: average value (cm$^{-3}$) of the density of the $Z_{1/2}$ centers at 10 locations)

(6) A method for manufacturing a SiC epitaxial wafer according to another embodiment of the present invention includes a formation step of forming a SiC epitaxial layer on a first surface of a SiC substrate by a chemical vapor deposition method using a growth apparatus having a gas supply port for supplying a Si-based gas and a C-based gas and a gas discharge port, wherein the formation step includes an adjustment step of analyzing a gas discharged from the gas discharge port by quadrupole mass spectrometry, increasing an amount of supply of the C-based gas relative to the Si-based gas when an C/Si analysis ratio is lower than a target value, and decreasing the amount of supply of the C-based gas relative to the Si-based gas when the analyzed C/Si ratio is higher than the target value.

(7) The method for manufacturing a SiC epitaxial wafer of (6) may further include a test step, and a feedback step before the formation step, the test step may include a preliminary measurement step of measuring a weight and a surface area of a by-product in a growth apparatus, a first formation step of forming a SiC epitaxial layer on a first surface of a test SiC substrate while analyzing a gas discharged from a gas discharge port by quadrupole mass spectrometry using the growth apparatus in which the preliminary measurement step has been performed, an analysis step of analyzing a uniformity of a density of a $Z_{1/2}$ center in a depth direction in the SiC epitaxial layer of the SiC epitaxial wafer formed in the first formation step, and a measurement step of measuring the weight and the surface area of the by-product in the growth apparatus after the first forming step, and the feedback step may set the target value based on a result of the test step.

(8) In the method for manufacturing a SiC epitaxial wafer of (6) and (7), the analysis step may include a film thickness measurement step of measuring a film thickness of a SiC epitaxial layer on a SiC epitaxial wafer having a center (0,0) in a plan view and a radius R, a first evaluation step of evaluating the density of the $Z_{1/2}$ centers at five locations of (0,0), ($\pm$R/2,0), and (0,$\pm$R/2) from an outermost surface of the SiC epitaxial wafer by a deep level transient spectroscopy (DLTS) method, a removal step of removing a predetermined thickness of the SiC epitaxial layer, and a second evaluation step of evaluating, after the removal step, the density of the $Z_{1/2}$ centers at five positions of (0, 0), ($\pm$R/2, 0), and (0, $\pm$R/2) from the outermost surface of the SiC epitaxial wafer by the DLTS method, and the uniformity of the density of the $Z_{1/2}$ centers in the depth direction, which is obtained by dividing a difference between the density of the $Z_{1/2}$ centers in the first evaluation step and the density of the $Z_{1/2}$ centers in the second evaluation step at the same location in a plan view by a predetermined thickness, may be analyzed.

(9) A SiC device according to yet another embodiment of the present invention includes a SiC substrate, and a SiC epitaxial layer formed on a first surface of the SiC substrate, wherein a uniformity of a $Z_{1/2}$ center density in a depth direction in the SiC epitaxial layer is less than 0.5 (%/$\mu$m).

According to the present invention, it is possible to provide a SiC epitaxial wafer, a method for manufacturing a SiC epitaxial wafer, and a SiC device in which a carrier lifetime can be estimated and a variation in a density of a $Z_{1/2}$ center in a depth direction of the SiC epitaxial layer is curbed.

BRIEF DESCRIPTION OF THE DRAWINGS

FIG. 1 is a cross-sectional view showing an example of a configuration of a SiC epitaxial wafer according to one embodiment of the present invention.

FIG. 2 is a plan view showing an example of the configuration of the SiC epitaxial wafer of FIG. 1.

FIG. 3 is a schematic diagram showing an example of a configuration of a measurement device for measuring a density of a $Z_{1/2}$ center.

FIG. 4 is a plan view showing an example of a cross-sectional configuration of the SiC epitaxial wafer along cutting line III-III in FIG. 1.

FIG. 5 is a an enlarged view of a region surrounded by a two-dot chain line in FIG. 1, and is schematic diagrams for describing uniformity in a depth direction of the density of the $Z_{1/2}$ centers in the SiC epitaxial wafer according to one embodiment of the present invention.

FIG. 6 is a schematic diagram showing an example of a method for manufacturing a SiC epitaxial wafer according to one embodiment of the present invention.

FIG. 7 is an image of setting a target value of an exhaust gas C/Si ratio.

FIG. 8 is an image of setting the target value of the exhaust gas C/Si ratio in accordance with changes in the density of the $Z_{1/2}$ centers over time.

FIG. 9 is an image of correcting the target value of the exhaust gas C/Si ratio based on a deposition area.

FIG. 10 is a plan view showing a configuration of a SiC device according to one embodiment of the present invention.

FIG. 11 is a graph calculates the $Z_{1/2}$ center density variation when performing the SiC epitaxial wafer manufacturing method of Example 1, including in-situ C/Si ratio control.

FIG. 12 is a graph calculates the $Z_{1/2}$ center density variation when performing the SiC epitaxial wafer manufacturing method of Comparative Example 1, which does not include in-situ C/Si ratio control.

DETAILED DESCRIPTION OF THE INVENTION

Hereinafter, an embodiment will be described in detail with reference to the drawings as appropriate. The drawings used in the following description may show characteristic parts enlarged for convenience in order to make features of the present invention easier to understand, and dimensional ratios of each component may differ from actual ones. The materials, dimensions, and the like exemplified in the following description are merely examples, and the present invention is not limited thereto and can be modified as appropriate within the scope that does not change the gist of the present invention.

[SiC epitaxial wafer]

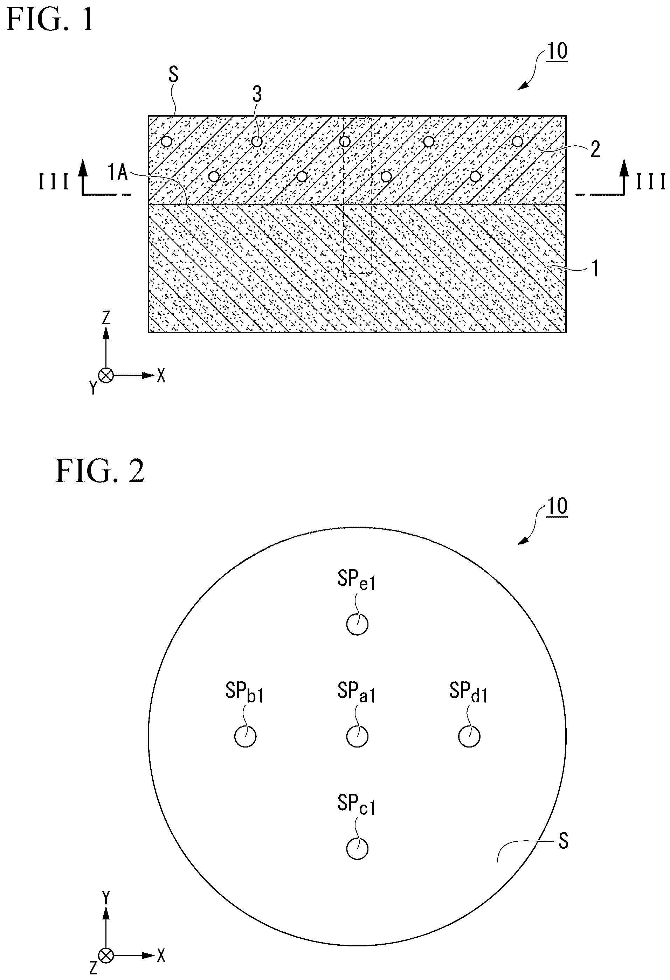

FIG. 1 is a cross-sectional view showing an example of a configuration of a SiC epitaxial wafer according to one embodiment of the present invention. The SiC epitaxial wafer 10 shown in FIG. 1 includes a SiC substrate 1 and a SiC epitaxial layer 2 formed on a first surface 1A of the SiC substrate 1, and a uniformity of a density of a $Z_{1/2}$ center in a depth direction of the SiC epitaxial layer 2 is less than 0.5 (%/$\mu$m).

The SiC substrate 1 is, for example, cut from a SiC ingot. The SiC ingot is grown on a SiC seed crystal by, for example, a sublimation method.

The SiC epitaxial layer 2 is formed on the first surface 1A of the SiC substrate 1. A film thickness of the SiC epitaxial layer is, for example, 8 $\mu$m or more and 500 $\mu$m or less, preferably 15 $\mu$m or more, more preferably 30 $\mu$m or more, and further preferably 50 $\mu$m or more. As the film thickness of the SiC epitaxial layer 2 increases, a film formation time becomes longer, and it is considered that growth conditions within the same plane become uniform. However, in the case of growth of planes at different depth positions, there is a concern that the growth conditions may change due to an influence of external factors such as deposition, and controlling the uniformity of the density of the $Z_{1/2}$ centers in the depth direction tends to become more difficult.

The SiC epitaxial layer 2 is formed on the SiC substrate 1 by, for example, a chemical vapor deposition (CVD) method. The SiC epitaxial layer 2 may have defects therein. The defects include stacking defects, point defects, and the like. The SiC epitaxial layer 2 has, for example, a $Z_{1/2}$ center 3 therein. The $Z_{1/2}$ center 3 is a point defect associated with a carbon vacancy. The $Z_{1/2}$ center 3 has a deep level ($E_c$-0.65 (eV)) and serves as a Shockley-Read-Hall (SRH) recombination center. That is, the $Z_{1/2}$ center 3 is one of carrier lifetime killer defects and affects a carrier lifetime.

As described above, the uniformity of the density of the $Z_{1/2}$ centers 3 in the depth direction in the SiC epitaxial layer 2 is less than 0.5 (%/$\mu$m). The uniformity of the density of the $Z_{1/2}$ centers 3 in the depth direction in the SiC epitaxial layer 2 is analyzed by an analysis method described below. Hereinafter, a method for analyzing the uniformity of the density of the $Z_{1/2}$ centers 3 in the depth direction in the SiC epitaxial layer 2 will be described with reference to a plan view of the SiC epitaxial wafer 10.

FIG. 2 is a plan view showing an example of the configuration of the SiC epitaxial wafer of FIG. 1. FIG. 2 shows measurement points $SP_{a1}$ to $SP_{e1}$ at which the density of the $Z_{1/2}$ centers is measured. When central coordinates of the SiC epitaxial wafer 10 in a plan view are (0, 0) and a radius is R, (X, Y) coordinates of the measurement points $SP_{a1}$, $SP_{b1}$, $SP_{c1}$, $SP_{d1}$, and $SP_{c1}$ are expressed as (0, 0), (-R/2, 0), (0, -R/2), (R/2, 0), and (0, R/2), respectively.

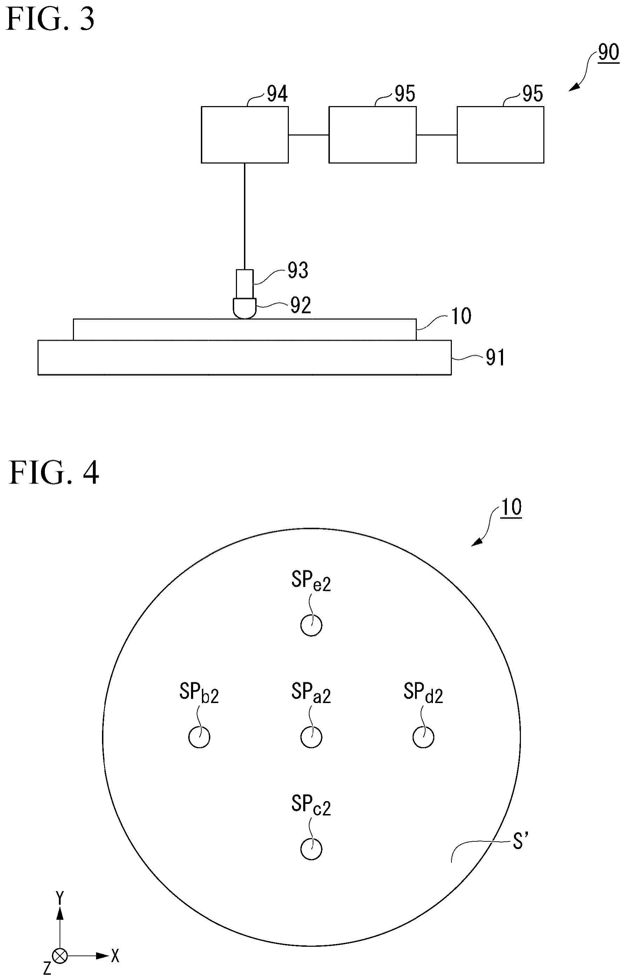

The density of the $Z_{1/2}$ centers is measured at the measurement points $SP_{a1}$ to $SP_{e1}$ by a deep level transient spectroscopy (DLTS) method. FIG. 3 is a schematic diagram showing an example of a configuration of a measurement device for measuring the density of the $Z_{1/2}$ centers. The measurement device 90 includes a stage 91, a contactor 92, a probe 93, a pulse power supply 94, a capacitance meter 95, and an evaluation unit 96.

The SiC epitaxial wafer 10 is placed on the stage 91. The stage 91 or the probe 93 is movable, and a relative position between the probe 93 and the SiC epitaxial wafer 10 may be changed.

The contactor 92 is located at a tip end of the probe 93. The contactor 92 comes into contact with the SiC epitaxial layer 2 of the SiC epitaxial wafer 10 during measurement. The contactor 92 is a terminal for applying a voltage to the SiC epitaxial wafer 10 and functions as a Schottky electrode. The contactor 92 is made of, for example, mercury. Mercury is a liquid at room temperature, and there is no need to deposit a metal electrode, as in a case when a metal that is solid at room temperature is used as the Schottky electrode. Therefore, there is no need to cut out the SiC epitaxial wafer 10 when the density of the $Z_{1/2}$ centers is measured in the vicinity of the outermost surface.

The pulse power supply 94 intermittently applies a voltage to the contactor 92. When the contactor 92 is in contact with the SiC epitaxial wafer 10, the voltage applied from the pulse power supply 94 is applied intermittently to the SiC epitaxial layer 2.

In the measurement of the density of the $Z_{1/2}$ centers due to the DLTS method, for example, the measurement is performed at an applied voltage that reaches a depth of about 10 $\mu$m from a surface S of the SiC epitaxial wafer 10. For example, a voltage is applied to the SiC epitaxial wafer 10 to reach a depth of about 7 to 10 $\mu$m from the surface S of the SiC epitaxial wafer 10.

In order to obtain the uniformity in the density of the $Z_{1/2}$ centers in the depth direction, it is necessary to measure the density of the $Z_{1/2}$ centers in the vicinity of the first surface 1A of the SiC substrate 1. FIG. 4 is a plan view showing an example of a cross-sectional configuration of the SiC epitaxial wafer taken along cutting line **III-III** of FIG. 1. FIG. 4 shows a surface S' in the vicinity of the first surface 1A of the SiC epitaxial wafer 10. Each of measurement points $SP_{a2}$ to $SP_{e2}$ shown in FIG. 4 overlaps each of the measurement points $SP_{a1}$ to $SP_{c1}$ in the depth direction. That is, the (X, Y) coordinates of the measurement points $SP_{a2}$, $SP_{b2}$, $SP_{c2}$, $SP_{d2}$, and $SP_{e2}$ are expressed as (0, 0), (-R/2, 0), (0, -R/2), (R/2, 0), and (0, R/2), respectively.

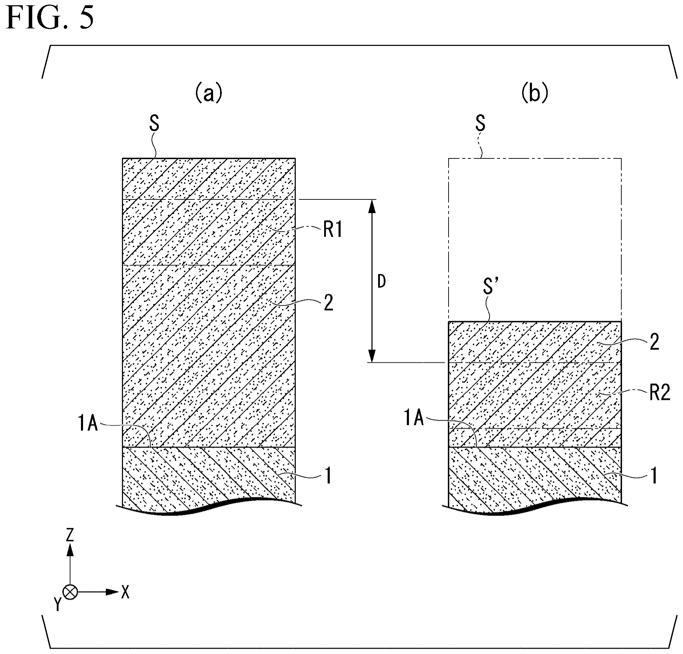

FIG. 5 includes two parts, which are left side (FIG. 5(a)) and right side (FIG. 5(b)). FIG. 5(a) is an enlarged view of a region surrounded by a two-dot chain line in FIG. 1, and FIGS. 5(a) and 5(b) are schematic diagrams for describing the uniformity of the density of the $Z_{1/2}$ centers in the depth direction in SiC epitaxial wafer 10 according to one embodiment of the present invention. An outermost surface S of the SiC epitaxial wafer 10 shown in FIG. 2 and a surface S' in the vicinity of the first surface 1A of the SiC epitaxial wafer 10 shown in FIG. 4 are spaced apart by a distance D in the depth direction. FIGS. 5(a) and 5(b) show a measurement region R1 when the density of the $Z_{1/2}$ centers is measured at one of the measurement points $SP_{a1}$ to $SP_{e1}$ shown in FIG. 2, and a measurement region R2 when the density of the $Z_{1/2}$ centers is measured at one of the measurement points $SP_{a2}$ to $SP_{e2}$ shown in FIG. 4. As shown in FIGS. 5(a) and 5(b), the outermost surface S and the surface S' in the vicinity of the first surface 1A are spaced apart in the depth direction by a distance D, and the measurement regions R1 and R2 do not overlap due to setting of the applied voltage when the DLTS method is performed. The measurement regions R1 and R2 have the same thickness. The measurement regions R1 and R2 may be set to, for example, 2 to 5 $\mu$m.

The uniformity of the density of the $Z_{1/2}$ centers of the SiC epitaxial wafer 10 in the depth direction may be calculated in units (%/$\mu$m) by multiplying a difference between the measurement points $SP_{a1}$ and $SP_{a2}$, $SP_{e1}$ and $SP_{b2}$, $SP_{c1}$ and $SP_{c2}$, $SP_{a1}$ and $SP_{d2}$, and $SP_{e1}$ and $SP_{e2}$ by 100 and dividing a result by a depth D ($\mu$m). For example, the uniformity of the density of the $Z_{1/2}$ centers in the depth direction at a center in a plan view of the SiC epitaxial wafer 10 is calculated in units (%/$\mu$m) by multiplying a difference (cm$^{-3}$) between the density of the $Z_{1/2}$ centers at the measurement point $SP_{a1}$ and the density of the $Z_{1/2}$ centers at the measurement point $SP_{a2}$ by 100 and dividing a result by the distance D ($\mu$m) of the measurement point in the depth direction. Values of D are, for example, $5\pm1$ $\mu$m, $9\pm2$ $\mu$m, $20\pm3$ $\mu$m, $40\pm4$ $\mu$m, $80\pm5$ $\mu$m, and $180\pm5$ $\mu$m when the film thicknesses of the SiC epitaxial layer 2 are 10 $\mu$m, 15 $\mu$m, 30 $\mu$m, 50 $\mu$m, 100 $\mu$m, and 200 $\mu$m, respectively.

In the SiC epitaxial wafer 10 according to the embodiment, the uniformity of each of the five measurement regions in the depth direction in the plan view is less than 0.5 (%/$\mu$m), preferably less than 0.4 (%/$\mu$m), and more preferably less than 0.3 (%/$\mu$m).

The density of the $Z_{1/2}$ centers at the measurement points $SP_{a1}$ to $SP_{e1}$ and $SP_{a2}$ to $SP_{e2}$ is preferably $1\times10^{11}$ cm$^{-3}$ or more and $1\times10^{13}$ cm$^{-3}$ or less, and more preferably $5\times10^{12}$ cm$^{-3}$ or less. When the density of the $Z_{1/2}$ centers is $1\times10^{11}$ cm$^{-3}$ or more, it is possible to specify the density of the $Z_{1/2}$ centers due to the DLTS method, which means that it is possible to estimate the carrier lifetime.

The density of the $Z_{1/2}$ centers may vary according to a position in an in-plane direction. That is, the values at the five measurement points $SP_{a1}$ to $SP_{e1}$ on the outermost surface S and the values at the five measurement points $SP_{a2}$ to

$SP_{e2}$ on the surface S' in the vicinity of the first surface 1A may differ. A variation in the density of the $Z_{1/2}$ centers at each of the measurement points within the same surface is preferably 5% or less. In the case of the outermost surface S, the variation in the $Z_{1/2}$ center density within the same surface is calculated in units of % by dividing a difference between a maximum value and a minimum value of the density of the $Z_{1/2}$ centers at the measurement points $SP_{a1}$ to $SP_{e1}$ by an average value and multiplying a result by 100.

When the maximum value of the density of the $Z_{1/2}$ centers at the 10 measurement points $SP_{a1}$ to $SP_{e1}$ and $SP_{a2}$ to $SP_{e2}$ is defined as Max and the minimum value is defined as Min, it is preferable that the maximum value Max and the minimum value Min satisfy the following Equation (1). The maximum value Max and the minimum value Min are typically densities of the $Z_{1/2}$ center of the measurement points on different surfaces.

$$[\{(\text{Max-Min})/\text{mean}\}\times100]<(5+0.5\times D)\ldots(1)$$

(D: distance ($\mu$m) between the surface in the vicinity of the outermost surface and the surface in the vicinity of the first surface,
mean: average value ($cm^{-3}$) of the $Z_{1/2}$ center density at 10 locations)

A doping concentration of the SiC epitaxial layer 2 is, for example, $1\times10^{13}$ $cm^{-3}$ or more and $1\times10^{17}$ $cm^{-3}$ or less. However, as the doping concentration decreases, a lower detection limit for point defects by the DLTS method described below becomes lower. Therefore, in the SiC epitaxial layer 2 in which the density of the $Z_{1/2}$ centers 3 is $1\times10^{13}$ $cm^{-3}$ or less, the doping concentration is preferably $1\times10^{15}$ $cm^{-3}$ or less. When the doping concentration is $1\times10^{13}$ $cm^{-3}$, the lower detection limit of the point defect by the DLTS method is thought to be $1.0\times10^{11}$ $cm^{-3}$.

The doping concentration is an effective doping concentration obtained by subtracting an acceptor concentration from a donor concentration in the case of n-type, and is an effective doping concentration obtained by subtracting a donor concentration from an acceptor concentration in the case of p-type. In the case of n-type, as the acceptor concentration decreases, it becomes better, and in the case of p-type, as the donor concentration decreases, it becomes better. The acceptor concentration in the case of n-type is, for example, $1\times10^{13}$ $cm^{-3}$ or less, and preferably $1\times10^{12}$ $cm^{-3}$ or less. In the case of p-type, the donor concentration is, for example, $1\times10^{13}$ $cm^{-3}$ or less, and preferably $1\times10^{12}$ $cm^{-3}$ or less.

Furthermore, the point defects caused by interstitial carbon in the SiC epitaxial layer 2 are, for example, $1\times10^{12}$ $cm^{-3}$ or less, and preferably $1\times10^{11}$ $cm^{-3}$ or less. Furthermore, the point defects caused by interstitial carbon may not be contained, for example, in the SiC epitaxial layer 2. The point defects caused by interstitial carbon are defects caused by carbon present in gaps between lattices. The point defects caused by interstitial carbon include, for example, an $EH_1$ center, an $EH_3$ center, an $RD_3$ center, an $ON_1$ center, and an $ON_2$ center. A density of each of the $EH_1$ center, $EH_3$ center, and $RD_3$ center is preferably $1\times10^{11}$ $cm^{-3}$ or less, and a density of each of the $ON_1$ center and $ON_2$ center is preferably $1\times10^{11}$ $cm^{-3}$ or less.

Carbon elements that become the point defects caused by interstitial carbon eliminate the $Z_{1/2}$ center 3 by a heat treatment. On the other hand, the point defects themselves affect characteristics of SiC devices. The number of $Z_{1/2}$ centers 3 may be controlled by irradiating the SiC epitaxial layer 2 with an electron beam. However, irradiating the SiC epitaxial layer 2 with an electron beam simultaneously generates the point defects (for example, the $EH_1$ center, the $EH_3$ center, and the $RD_3$ center) caused by interstitial carbon. The $ON_1$ center and $ON_2$ center are defects that are generated simultaneously during treatments for eliminating the $Z_{1/2}$ center, such as carbon ion implantation and thermal oxidation, and it is difficult to completely reduce them by heat treatment. However, the $ON_1$ center and the $ON_2$ center are not present in the SiC epitaxial layer 2 as epitaxially grown, or even when they are present, their concentrations are sufficiently low. Therefore, according to a method for manufacturing a SiC epitaxial wafer, which will be described below and which is capable of manufacturing a SiC epitaxial wafer having high uniformity of the density of the $Z_{1/2}$ centers in the depth direction without post-treatment, it is possible to provide a wafer having low point defects and low density of the low $Z_{1/2}$ center, as described above.

A diameter of the SiC epitaxial wafer 10 is, for example, 100 mm or more, preferably 150 mm or more, and more preferably 200 mm or more. Here, the diameter described in this paragraph is not exact and allows an error of about $\pm1$ mm. In other words, the wafer having a diameter of 100 mm means a wafer of 99 mm or more and 101 mm or less, the wafer having a diameter of 150 mm means a wafer of 149 mm or more and 151 mm or less, and the wafer having a diameter of 200 mm means a wafer of 199 mm or more and 201 mm or less. The diameter of the SiC epitaxial wafer 10 may be, for example, 305 mm or less (306 mm or less with an allowance of 1 mm).

A drift layer is a layer through which a drift current flows and on which elements such as transistors are formed when a SiC device which will be described below is manufactured. The drift current is a current generated by a flow of carriers when a voltage is applied to a semiconductor.

Next, in order to describe the method for manufacturing a SiC epitaxial wafer according to the embodiment, a growth apparatus that can be used in the method for manufacturing a SiC epitaxial wafer will be first described.

[Growth Apparatus]

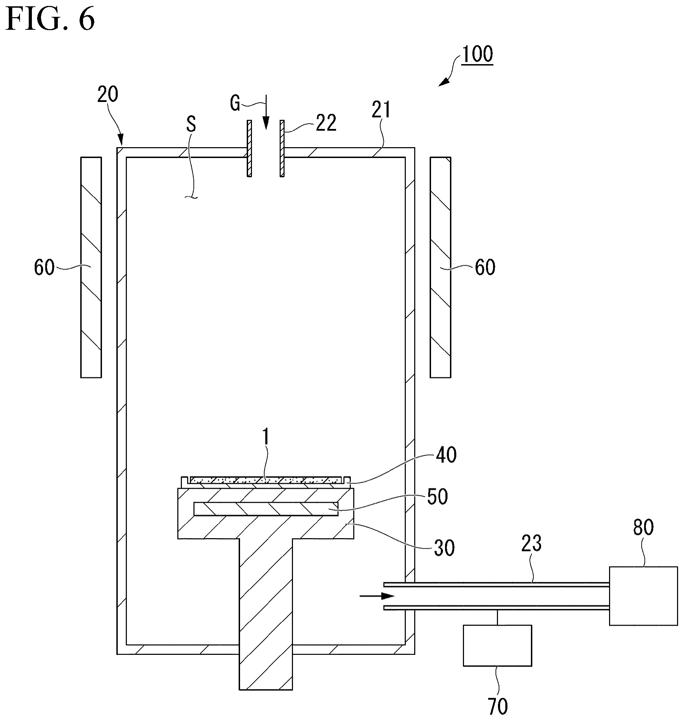

FIG. 6 is a schematic diagram showing an example of a method for manufacturing a SiC epitaxial wafer according to one embodiment of the present invention. The growth apparatus 100 shown in FIG. 6 includes, for example, a chamber 20, a support body 30, a susceptor 40, a lower heater 50, and an upper heater 60. FIG. 6 shows a state in which the SiC substrate 1 is placed on a susceptor 40. The growth apparatus 100 shown in FIG. 6 is an example of an apparatus which can be used in the method for manufacturing a SiC epitaxial wafer according to the embodiment, and other configurations may also be used. For example, the growth apparatus 100 is a vertical furnace that supplies a source gas from above the first surface 1A of the SiC substrate **1,** but it may also be a horizontal furnace that supplies the source gas parallel to the first surface 1A of the SiC substrate 1. Further, a single wafer furnace capable of simultaneously forming films on a plurality of SiC substrates 1 may be used.

The chamber 20 includes, for example, a main body 21, a gas supply port 22, and a gas discharge port 23. The gas discharge port 23 is connected to an exhaust pump 80. An analyzer 70 is provided at the gas discharge port 23. The analyzer 70 is, for example, a quadrupole mass analyzer. The analyzer 70 is capable of analyzing components of a gas exhausted from the gas discharge port 23.

The support body 30 supports the SiC substrate 1. The support body 30 is rotatable about its axis. The SiC substrate 1 is placed on the support body 30, for example, in a state in which the SiC substrate 1 is placed on the susceptor 40. The susceptor 40 is transferred into the chamber 20 with the SiC substrate 1 placed thereon. The lower heater 50 is, for example, located within the support body 30 and heats the SiC substrate 1. The upper heater 60 heats an upper portion of the chamber 20. A member exposed in a film formation space S is, for example, a carbon member, and a surface thereof may be coated with SiC or TaC.

[Method for manufacturing SiC epitaxial wafer]

A method for manufacturing a SiC epitaxial wafer according to one embodiment of the present invention includes a formation step of forming a SiC epitaxial layer on the first surface of the SiC substrate by a chemical vapor deposition method using a growth apparatus with a gas supply port for supplying Si-based gas and C-based gas and a gas discharge port.

<Formation step>

The formation step includes an adjustment step of analyzing the gas discharged from the gas discharge port 23 using quadrupole mass spectrometry, increasing an amount of supply of a C-based gas relative to the Si-based gas when an analyzed C/Si ratio is lower than a target value, and decreasing the amount of supply of a C-based gas relative to the Si-based gas when the analyzed C/Si ratio is higher than the target value.

The formation step includes, for example, a temperature increase step, a growth step, and a temperature decrease step.

In the temperature increase step, a temperature inside the growth apparatus 100 is raised to a growth temperature $T_2$. The growth temperature $T_2$ is, for example, a temperature in a range of 1500°C to 1750°C.

The growth step is a step which follows the temperature increase step and in which a Si-based gas and a C-based gas are supplied at a growth temperature $T_2$ to epitaxially grow the SiC epitaxial layer 2 on the SiC substrate 1. The adjustment step is a step which occurs during the growth step.

The temperature decrease step is a step which follows the growth step and decreases the temperature inside the growth apparatus 100.

Here, the temperature inside the growth apparatus 100 is a temperature of the SiC substrate 1 or the SiC epitaxial wafer 10 measured by a radiation thermometer (a pyrometer).

The Si-based gas is a source gas containing Si in its molecules. Examples of the Si-based gas includes silane ($SiH_4$), dichlorosilane ($SiH_2Cl_2$), trichlorosilane ($SiHCl_3$), tetrachlorosilane ($SiCl_4$), and the like. The C-based gas is a source gas containing C in its molecule. Examples of the C-based gas include propane ($C_3H_8$), ethylene ($C_2H_4$), and the like. A dopant gas is a gas containing an element which serves as a carrier. The dopant gas is, for example, nitrogen, ammonia, and the like. A purge gas is a gas that carries the gases to the SiC substrate 1, and is, for example, hydrogen that is inactive with respect to SiC.

As described above, the formation step includes the adjustment step of analyzing the gas discharged from the gas discharge port using quadrupole mass spectrometry (QMS analysis), increasing the amount of supply of the C-based gas relative to the Si-based gas when the C/Si ratio of the analyzed gas is lower than the target value, and decreasing the amount of supply of the C-based gas relative to the Si-based gas when the analyzed C/Si ratio is higher than the target value. The adjustment step is a step which occurs during the growth step, and is performed in parallel with the formation of the SiC epitaxial layer 2 on the SiC substrate 1. In other words, the adjustment step is a step performed in situ.

During the formation step, the source gas supplied into the chamber 20 may not be supplied to the SiC substrate 1 at an intended C/Si ratio due to, for example, deposition occurring on the upstream side close to the gas supply port 22 with respect to SiC substrate 1 in the chamber 20.

In such a case, when the C/Si ratio of the source gas discharged from the gas discharge port 23 is lower than the target value in the adjustment step, the amount of supply of the C-based gas is increased. Furthermore, when the C/Si ratio of the source gas discharged from the gas discharge port 23 is higher than the target value, the amount of supply of the C-based gas is decreased. The adjustment step is preferably carried out so that the C/Si ratio is always within a range of a target value of $\pm 0.005$, and more preferably within a range of a target value of $\pm 0.003$.

By controlling a flow rate of the source gas in the growth step as described above, the C/Si ratio supplied to the SiC substrate 1 can be made closer to an ideal value. In the embodiment, the formation of the $Z_{1/2}$ center associated with carbon vacancies can be curbed, and the uniformity of the density of the $Z_{1/2}$ centers in the depth direction in the SiC epitaxial layer 2 can be improved.

Furthermore, the method for manufacturing a SiC epitaxial wafer according to the embodiment may further include one or more test steps and feedback steps prior to the formation step, and may set the target value for the supply of the source gas in the formation step based on results of the test step.

In the formation step of forming the SiC epitaxial layer 2, since it is believed that a change of 0.005 in the C/Si ratio will cause a change of 5% in the density ($cm^{-3}$) of the $Z_{1/2}$ center, it is important to control the C/Si ratio during growth, and external environment may change at the beginning of growth and immediately before completion of the growth, and it is therefore preferable that the C/Si ratio in the source gas to be supplied be determined in consideration of the external environment.

<Test step>

The test step includes a first formation step, an analysis step, and a measurement step, and preferably further includes a preliminary measurement step. The test step is performed at least once, but may be performed multiple times.

(Preliminary measurement step)

In the preliminary measurement step, a weight and a specific surface area of a by-product (a deposition) in the growth apparatus 100 are measured. In the growth apparatus 100, the by-product may be generated in a region between the gas supply port 22 and the gas discharge port 23 (that is, a region between a growth area and an exhaust gas) in the chamber 20. A weight of the by-product in the growth apparatus 100 is measured, for example, by an electronic weighing scale. The above-described region is a specific region at any position between the gas supply port 22 and the gas discharge port 23. Throughout the series of steps in the test step, the specific region is fixed and does not change.

A surface area of the by-product in the growth apparatus 100 may be confirmed by sampling the by-product in the above-described area (the growth area to the exhaust gas) and measuring the by-product with a laser microscope. The target value of the C/Si ratio, which is set in advance, may be corrected to be lowered based on a deposition area (a weight of the deposition $\times$ the specific surface area) measured in the preliminary measurement step, using a method similar to a procedure which will be described below.

(First formation step)

In the first formation step, a SiC epitaxial layer is formed on a first surface of a test SiC substrate using the growth apparatus 100 in which the preliminary measurement step has been performed, while the gas discharged from the gas discharge port 23 is analyzed by quadrupole mass spectrometry. The growth is carried out while the gas discharged from the gas discharge port is analyzed by quadrupole mass spectrometry (QMS analysis). The growth is carried out so that the C/Si ratio of the gas analyzed by the QMS analysis is constant at a target value. For example, the first formation step includes the adjustment step of increasing the amount of supply of the C-based gas relative to the Si-based gas when the analyzed C/Si ratio is lower than the target value, and decreasing the amount of supply of the C-based gas relative to the Si-based gas when the analyzed C/Si ratio is higher than the target value. The adjustment step is a step which occurs during the first formation step, and is performed in parallel with the formation of the SiC epitaxial layer 2 on the SiC substrate 1. That is, the adjusting step is a step performed in situ. The control of the C/Si ratio is preferably performed by a proportional-integral-differential (PID) controller. During growth, the C/Si ratio of the analyzed gas is controlled to be constant at a predetermined target value. Preferably, the C/Si ratio of the analyzed gas is controlled to be always within a range of a predetermined value of $\pm 0.005$, and more preferably, the C/Si ratio of the analyzed gas is controlled to be always within a range of a predetermined value of $\pm 0.004$, and even more preferably the C/Si ratio of the analyzed gas is controlled to be always within a range of a predetermined value of $\pm 0.003$. Specifically, it is preferable to control the exhaust gas C/Si ratio such that the difference from the target value of exhaust gas C/Si ratio to be always within a range of $\pm 0.005$, it is more preferable to control it such that the difference to be always within a range of $\pm 0.004$, and it is even more preferable to control it such that the difference to be always within a range of $\pm 0.003$. It is noted that the C/Si ratio equals 1 when the flow rates of the C-based gas and the flow rates of the Si-based gas are equal. That is, when the C/Si ratio analyzed by QMS analysis is 1, it means the flow rate of C-type gas discharged from the gas discharge port is 100% relative to the flow rate of Si-type gas discharged from the gas discharge port. Therefore, a C/Si ratio of 0.001 equals 0.1%, 0.003 equals 0.3%, 0.004 equals 0.4%, and 0.005 equals 0.5%.

In the adjustment step, gas species that mainly contribute to a reaction are measured by the QMS analysis to perform a qualitative C/Si evaluation. Ion species to be measured are determined according to each reaction process, for example, $[C_2H_2^+]/[Si^+]$ for a system containing only Si-based gas and C-based gas, or $[C_2H_2^+]/[SiCl_2^+]$ for a system containing Cl-based gas in addition to Si-based gas and C-based gas, and an increase or decrease in the ratio is adjusted to be constant at a certain target value as an increase or decrease in the qualitative C/Si ratio.

(Analysis step)

In the analysis step, the uniformity of the density of the $Z_{1/2}$ centers in the depth direction in the SiC epitaxial layer of the SiC epitaxial wafer formed in the first formation step is analyzed.

The variation in the density of the $Z_{1/2}$ centers in the depth direction in the SiC epitaxial layer is measured. In the analysis step, when the variation in the density of the $Z_{1/2}$ centers in the depth direction in the SiC epitaxial layer is measured, the measurement can be performed by the same method as in the above embodiment. That is, when the analysis step is performed by a destructive inspection, for example, the analysis step includes a film thickness measurement step, a first evaluation step, a removal step, and a second evaluation step. Furthermore, in the DLTS method, when the measurement can be performed by controlling an applied voltage from the outermost surface S so that a measurement range of a measurement region R2, which is spaced a distance D from a measurement region R1 on the outermost surface S side, is approximately the same as a width of a depth of the measurement region R1, the measurement may be performed non-destructively. In other words, when the depth of the measurement region R1 is a to b $\mu$m from the outermost surface S, and a region of which a distance from a surface that is spaced a distance D in the depth direction from an upper surface of the measurement region R1 is a to b $\mu$m (D+a to b ($\mu$m) from the outermost surface S) can be measured from the outermost surface S by the control of the voltage, the removal step may be omitted. In this case, the analysis step includes the film thickness measurement step, the first evaluation step, and the second evaluation step.

In the film thickness measurement step, a film thickness of the SiC epitaxial layer 2 is measured by a Fourier transform infrared spectroscopy method (an FT-IR method).

In the first evaluation step, the measurement is performed by the DLTS method at five locations, (0,0), ($\pm$R/2,0), and (0,$\pm$R/2), from the outermost surface S of a SiC epitaxial wafer having a center (0,0) and a radius R in a plan view, and the density of the $Z_{1/2}$ centers in the surface in the vicinity of the outermost surface is measured. The density of the $Z_{1/2}$ centers in the surface in the vicinity of the outermost surface is measured, for example, by applying a voltage to the SiC epitaxial wafer 10 to a depth of about 7 to 10 $\mu$m from the surface S of the SiC epitaxial wafer 10 in the DLTS method. In this way, a voltage is applied so that a thickness of the measurement region R1 is about 2 to 5 $\mu$m, such as (10-7 =) 3 $\mu$m.

When the destructive inspection is performed, in the removal step, the SiC epitaxial layer 2 is thinned by removing a thickness D of the SiC epitaxial layer 2 until a distance between the surface of the SiC epitaxial layer 2 and the first surface 1A becomes, for example, 12 $\mu$m, according to a result of the film thickness measurement step. The removal step may be performed by, for example, grinding or polishing.

In the second evaluation step, the density of the $Z_{1/2}$ centers in the surface in the vicinity of the first surface is measured by the DLTS method. The second evaluation step may be performed under the same conditions as those in the first evaluation step. That is, the density of the $Z_{1/2}$ centers is measured by the DLTS method at five locations, (0,0), ($\pm$R/2,0), and (0,$\pm$R/2), in a plan view so that the depth of the measurement region from the removed and exposed surface S is 7 to 10 $\mu$m. When the analysis step is performed by the non-destructive inspection using the control of the applied voltage, the applied voltage is controlled so that the measurement region is located at a distance of 2 to 5 $\mu$m from the first surface 1A.

The uniformity of the density of the $Z_{1/2}$ centers in the depth direction is analyzed based on the density of the $Z_{1/2}$ centers in the surface in the vicinity of the outermost surface S and the surface in the vicinity of the first surface 1A of the SiC substrate 1 obtained by the above-described measurement and the thickness D ($\mu$m) of the removed SiC epitaxial layer. Furthermore, the variation in the density of the $Z_{1/2}$ centers in the SiC epitaxial layer 2 may be analyzed based on Equation (1) using the maximum value Max and minimum value Min of the density of the $Z_{1/2}$ centers at the 10 locations.

$$[\{(Max\text{-}Min)/mean\}\times 100]<(5+0.5\times D)\ldots(1)$$

(D: distance ($\mu$m) between the surface in the vicinity of the outermost surface and the surface in the vicinity of the first surface,

mean: average value (cm$^{-3}$) of the density of the $Z_{1/2}$ centers at 10 locations)

(Measurement step)

In the measurement step, the weight and the surface area of the by-product in the growth apparatus 100 after the first formation step are measured. The weight and the surface area of the by-product in the growth apparatus 100 may be measured by the same method as in the preliminary measurement step. A region in which the measurement is performed in the measurement step is a region between the gas supply port 22 and the gas discharge port 23, which is the specific region at the same position as the region in which the measurement step was performed.

<Feedback step>

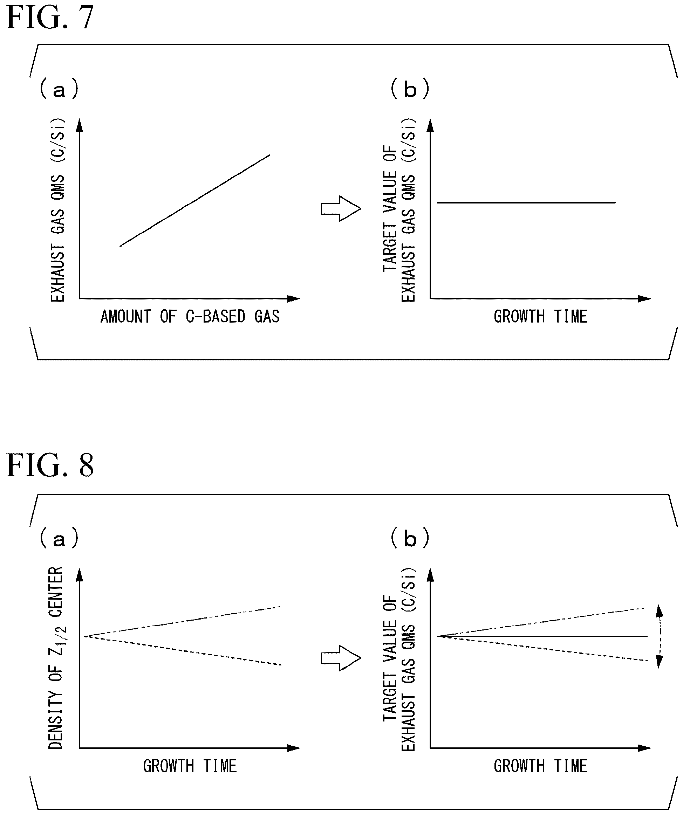

In the feedback step, the target value for the amount of supply of the Si-based gas and the C-based gas during the formation step of this step, which actually produces the SiC epitaxial wafer 10, is set based on the results of the test step. That is, a standard (the target value) of the amount of the source gas to be flowed in the formation step is set based on the results of the (preliminary measurement step,) the analysis step, and the measurement step. The standard (the target value) of the source gas may be constant over time, or may vary over time. First, a constant target value for the C/Si ratio in the exhaust gas over time is set based on the C/Si ratio in the exhaust gas QMS analysis. FIG. 7 shows an image of setting the target value for the C/Si ratio in the exhaust gas.

Next, when the density of the $Z_{1/2}$ center changes in a specific way with the passage of growth time, a target value for the C/Si ratio that changes with time is set so as to correspond to the change with time. For example, the target value may be proportional to the growth time. Specifically, when the density of the $Z_{1/2}$ centers decreases with the passage of growth time, the standard (the target value) of the C/Si ratio is set to decrease with time, and when the density of the $Z_{1/2}$ centers increases with the passage of growth time, the standard (the target value) of the C/Si ratio is set to increase with time (the first adjustment step). FIG. 8 shows an image of setting the target value of the C/Si ratio in the exhaust gas in response to the change over time in the density of the formed $Z_{1/2}$ center. The adjustment may be made as shown by a dashed line in FIG. 8B in response to a result of a dashed line in FIG. 8A, or the adjustment can be made as shown by a two point chain line in FIG. 8B in response to a result of a two point chain line in FIG. 8A.

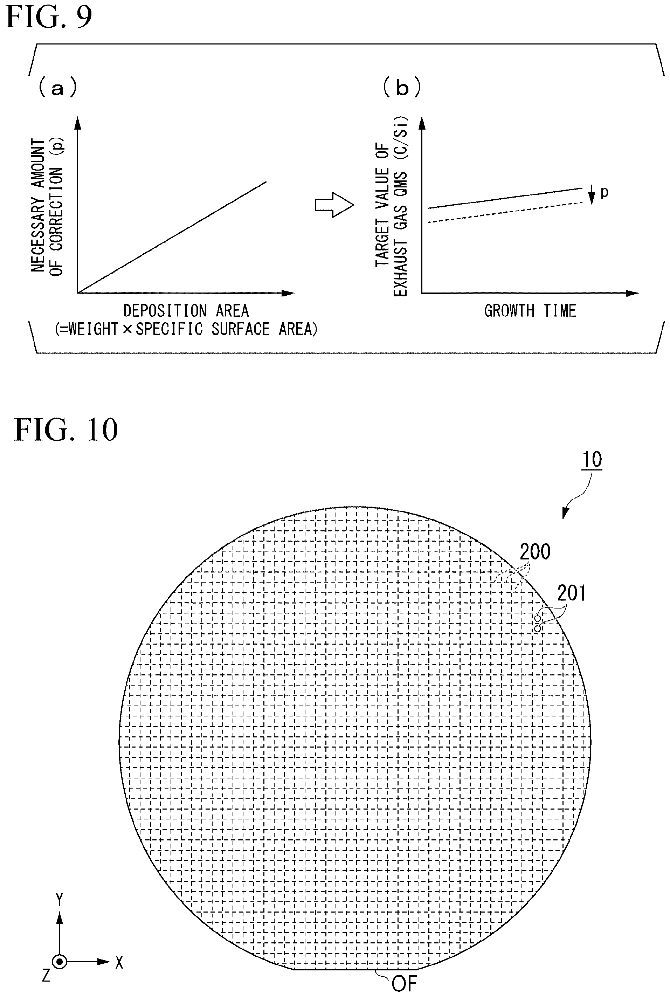

Next, taking into consideration that a divergence occurs between the measured value of the C/Si ratio in the exhaust gas and the C/Si ratio of the growth area corresponding to a deposition area (the weight of the deposition $\times$ the specific surface area of the deposition) in the apparatus, the target value of the C/Si ratio in the exhaust gas set in the first adjustment step is corrected in accordance with the deposition area in the apparatus (the second adjustment step). FIG. 9 is an image of correcting the target value of the C/Si ratio in the exhaust gas based on the deposition area. An amount of correction is set based on a map such as that shown in FIG. 9A that has been obtained in advance through multiple tests. Here, preferably, a map relating to measurement locations of the deposition area is used. FIG. 9B shows a case in which the correction is made from a solid line graph in FIG. 9B by a necessary amount (p) of correction calculated from the measured deposition area using the map in FIG. 9A. As the deposition area increases, a divergence between the measurement value of the C/Si in the exhaust gas and the C/Si in the growth area occurs, the deposition of the by-product has a C/Si ratio <1, and an amount of generation of the by-product increases with the deposition area. Therefore, the deposition area has to be set so that the measured C/Si in the exhaust gas is made larger than the C/Si in the growth area.

In this way, the target value for the amount of supply of each of the Si-based gas and the C-based gas in the formation step of this step can be set.

According to the method for manufacturing a SiC epitaxial wafer according to the embodiment, since the density of the $Z_{1/2}$ centers can be measured, it is possible to estimate the carrier lifetime and provide a SiC epitaxial wafer in which the variation in the density of the $Z_{1/2}$ centers in the depth direction in the SiC epitaxial layer is curbed. Furthermore, according to the method for manufacturing a SiC epitaxial wafer according to the embodiment, it is possible to provide a SiC epitaxial wafer with a uniform density of the $Z_{1/2}$ centers without performing a process of reducing the density of the $Z_{1/2}$ centers after the SiC epitaxial layer 2 is formed.

[SiC Device]

A SiC device according to one embodiment of the present invention includes the SiC substrate and the SiC epitaxial layer formed on the first surface of the SiC substrate, and the uniformity of the density of the $Z_{1/2}$ centers in the depth direction in the SiC epitaxial layer is less than 0.5 (%/$\mu$m). The SiC substrate and SiC epitaxial layer provided in the SiC device can be the SiC substrate and SiC epitaxial layer of the SiC epitaxial wafer according to the above-described embodiment.

The SiC device is obtained from the SiC epitaxial wafer 10 according to the above-described embodiment. FIG. 10 is a plan view showing a configuration of the SiC device according to one embodiment of the present invention. The SiC device 200 may be manufactured by forming devices such as transistors on the SiC epitaxial wafer 10 and making the wafer into chips. In FIG. 10, each of rectangular sections of the SiC epitaxial wafer 10 is a SiC device. The SiC device 200 may be manufactured by forming devices such as transistors and diodes on the SiC epitaxial wafer 10 after making the SiC epitaxial wafer 10 into chips.

The SiC device 200 according to the embodiment includes a chipped SiC substrate and a SiC epitaxial layer provided on one surface of the chipped SiC substrate. Devices such as transistors are formed on a drift layer of the SiC epitaxial layer. The configurations of the SiC substrate, a buffer layer, and the drift layer in the SiC device 200 are the same as those of the SiC epitaxial wafer 10 before being made into chips.

When the SiC device 200 further includes members other than the SiC substrate and the SiC epitaxial layer, the density of the $Z_{1/2}$ centers in the SiC epitaxial layer of the SiC device 200 may be measured after regions other than the SiC substrate and the SiC epitaxial layer are removed from the SiC device 200. The regions are removed by, for example, grinding or polishing. A process of removing the regions does not change a distribution of the $Z_{1/2}$ in the SiC epitaxial layer. The density of the $Z_{1/2}$ centers in the SiC epitaxial layer of the SiC device 200 may be measured at one point of a center 201 in a plan view of the SiC device 200 in the same manner as a method for measuring the uniformity in the depth direction at the measurement points $SP_{a1}$ and $SP_{a2}$ on the epitaxial wafer. That is, first, in the SiC epitaxial layer of the SiC device, the density of the $Z_{1/2}$ centers at the measurement point $SP_{a1}$ is measured, then the applied voltage is adjusted, and the density of the $Z_{1/2}$ centers may be measured at the measurement point $SP_{a2}$.

The uniformity of the density of the $Z_{1/2}$ centers in the depth direction in the SiC epitaxial layer of the SiC device 200 is less than 0.5 (%/$\mu$m), preferably less than 0.4 (%/$\mu$m), and more preferably less than 0.3 (%/$\mu$m).

Furthermore, the density of the $Z_{1/2}$ centers in the SiC epitaxial layer of the SiC device 200 is preferably $1 \times 10^{11}$ cm$^{-3}$ or more and $1 \times 10^{13}$ cm$^{-3}$ or less, and more preferably $5 \times 10^{12}$ cm$^{-3}$ or less.

As described above, the SiC epitaxial wafer 10 according to the above-described embodiment has excellent uniformity of the density of the $Z_{1/2}$ centers in the depth direction in the buffer layer, and the SiC epitaxial layer in the SiC device 200 also has excellent uniformity of the density of the $Z_{1/2}$ centers in the depth direction. Therefore, the carrier lifetime can be evaluated more accurately.

Although the preferred embodiments of the present invention have been described in detail above, the present invention is not limited to the specific embodiments, and various modifications and changes are possible within the scope of the gist of the present invention as set forth in the claims. For example, the upper and lower limits of a numerical range can be arbitrarily combined to define a preferred range, the upper limits of a numerical range can be arbitrarily combined to define a preferred range, and the lower limits of a numerical range can be arbitrarily combined to define a preferred range.

Examples

[Example 1]

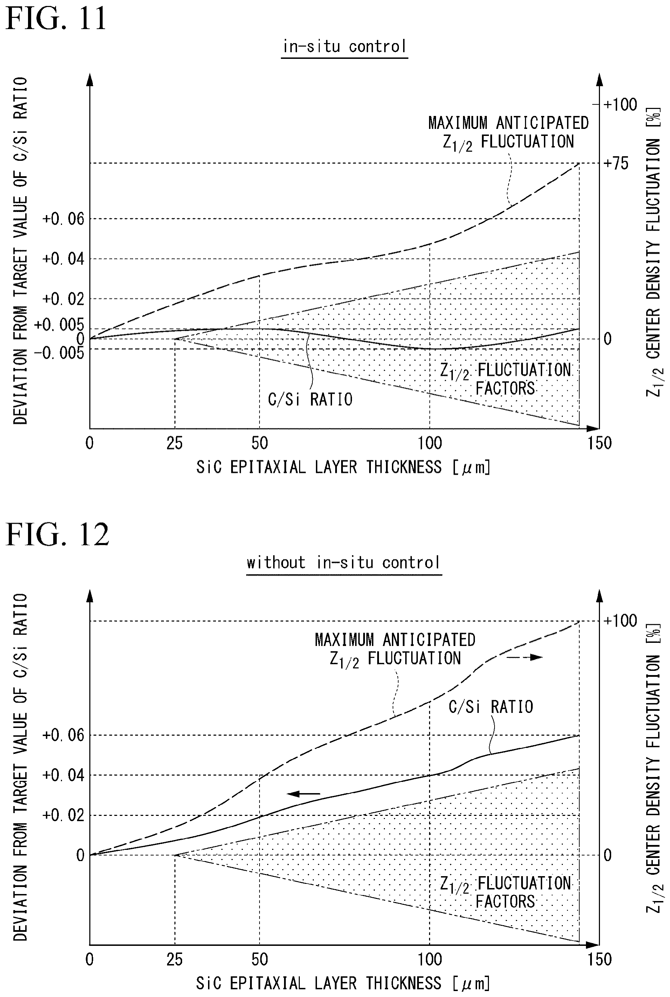

By the method for manufacturing SiC epitaxial wafers of the present disclosure, the C/Si ratio was adjusted in situ, and the thickness dependence of the SiC epitaxial layer's $Z_{1/2}$ center density on the SiC epitaxial wafer was determined. Specifically, assuming that the $Z_{1/2}$ center density variation is linearly dependent on the thickness of the SiC epitaxial layer, corresponding to the variation in the C/Si ratio during in-situ adjustment and the thickness of the SiC epitaxial layer, and calculated the maximum possible $Z_{1/2}$ center density variation achievable when the C/Si ratio and other $Z_{1/2}$ center density variation factors are maximized. In Example 1, a configuration is assumed where the C/Si ratio in the exhaust gas is adjusted so that the difference from the target C/Si ratio in the exhaust gas falls within $\pm 0.005$. By adjusting the C/Si ratio in situ, it is anticipated that the deviation from the target C/Si ratio will exhibit a sinusoidal variation with respect to the SiC epitaxial layer thickness, as approximately shown in FIG. 11.

FIG. 11 is a graph showing the calculated $Z_{1/2}$ center density variation when the SiC epitaxial wafer fabrication method including C/Si ratio control (in-situ) according to Example 1 is performed. FIG. 11 shows both the thickness dependence of the $Z_{1/2}$ center density variation factor (other than the C/Si ratio) on the SiC epitaxial layer thickness and the thickness dependence of the difference between the C/Si ratio and its target value on the SiC epitaxial layer thickness. In FG. 11, the $Z_{1/2}$ variation factor is considered to take any value within the area enclosed by the double-dotted line. In Figure 11, the $Z_{1/2}$ fluctuation factor is represented by a maximum value of {(SiC epitaxial layer thickness - 25) $\times$ 0.0092} $\times$ 100 (%). Using this, the $Z_{1/2}$ center density fluctuation is expressed by the following Equation (2).

$Z_{1/2}$ Center Density Fluctuation = {(the difference between the C/Si ratio and its target value) $\times$ 10 + (SiC Epitaxial Layer Thickness - 10) $\times$ 0.0092} $\times$ 100 (%)... (2)

(2)

Table 1 summarizes the deviation from the target C/Si ratio and the $Z_{1/2}$ center density variation for SiC epitaxial layer thicknesses of 0 μm, 50 μm, 100 μm, and 150 μm. It is noted that, in Table 1, the difference between the C/Si ratio and its target value is positive when the C-base gas flow rate ratio in the exhaust gas is higher than the target C-base gas flow rate ratio.

[Table 1]

| SiC Epitaxial Layer Thickness | 0 μm | 50 μm | 100 μm | 150 μm |
|---|---|---|---|---|
| Difference between the C/Si ratio and its target value | ±0.00 | +0.005 | -0.005 | +0.005 |
| Z1/2 Center Density Fluctuation | 0.00% | 25% | 40% | 75% |

[Comparative Example 1]

The only modification from Example 1 was to assume no in-situ control of the C/Si ratio, and the thickness dependence of the SiC epitaxial layer's $Z_{1/2}$ center density variation was calculated. In Comparative Example 1, since the C/Si ratio is not controlled in situ, it is conceivable that the C/Si ratio will exhibit either an increasing or decreasing trend over time. Assuming an increasing trend for Comparative Example 1, it was assumed that the C/Si ratio would increase as the thickness of the SiC epitaxial layer increased. Factors affecting the $Z_{1/2}$ center density variation other than the C/Si ratio were estimated similarly to Example 1. That is, for Comparative Example 1, the thickness dependence of the $Z_{1/2}$ center density variation on the SiC epitaxial layer thickness was also calculated using Equation (2).

Figure 12 is a graph showing the calculated $Z_{1/2}$ center density variation when the SiC epitaxial wafer manufacturing method for Comparative Example 1, which does not include C/Si ratio control (in-situ), is performed.

Table 2 summarizes the difference from the target C/Si ratio and the $Z_{1/2}$ center density variation for SiC epitaxial layer thicknesses of 0 μm, 50 μm, 100 μm, and 150 μm.

[Table 2]

| SiC Epitaxial Layer Thickness | 0 μm | 50 μm | 100 μm | 150 μm |
|---|---|---|---|---|
| Difference between the C/Si ratio and its target value | ±0.00 | +0.002 | +0.004 | +0.006 |
| Z1/2 Center Density Fluctuation | 0.00% | 35% | 71% | 93% |

As confirmed by comparing FIGS. 11 and 12, or Tables 1 and 2, it was confirmed that during the formation process of forming a SiC epitaxial layer by supplying Si-based gas and C-based gas, by in-situ controlling the C/Si ratio and minimizing the difference between the C/Si ratio and the target value, the $Z_{1/2}$ center density fluctuation can be reduced at any film thickness. It is Noted that the $Z_{1/2}$ center density fluctuation is a parameter concerning the distribution of $Z_{1/2}$ center density in the depth direction of the SiC epitaxial layer. It correlates with variations in $Z_{1/2}$ center density, such as the value of [{ (Max - Min)/mean} $\times$ 100] in Equation (1).

EXPLANATION OF REFERENCES

1 SiC substrate
1A First surface
2 SiC epitaxial layer
3 $Z_{1/2}$ center
10 SiC epitaxial wafer
20 Chamber
21 Main body
22 Gas supply port
23 Gas discharge port
30 Support body
40 Susceptor
50 Lower heater
60 Upper heater
100 Growth apparatus

S Outermost surface

**Claims**

1. A SiC epitaxial wafer comprising:

    a SiC substrate; and
    a SiC epitaxial layer formed on a first surface of the SiC substrate,
    wherein a uniformity of a density of a $Z_{1/2}$ center in a depth direction in the SiC epitaxial layer is less than 0.5 (%/$\mu$m).

2. The SiC epitaxial wafer of claim 1, wherein a diameter is 149 mm or more.

3. The SiC epitaxial wafer of claim 1, wherein a diameter is 199 mm or more.

4. The SiC epitaxial wafer of claim 1, wherein, when central coordinates in a plan view are (0,0) and a radius is R, the density of the $Z_{1/2}$ centers at 10 locations on a surface in the vicinity of an outermost surface in the depth direction and on a surface in the vicinity of the first surface at coordinates (0,0), ($\pm$R/2,0) and (0,$\pm$R/2) is $1\times10^{11}$ cm$^{-3}$ or more and $1.0\times10^{13}$ cm$^{-3}$ or less.

5. The SiC epitaxial wafer of claim 1, wherein, when central coordinate in a plan view are (0,0) and a radius is R, a maximum value Max and a minimum value Min of the density of the $Z_{1/2}$ centers at 10 locations on the surface in the vicinity of the outermost surface in the depth direction and on the surface in the vicinity of the first surface at coordinates (0, 0), ($\pm$R/2, 0), and (0, $\pm$R/2) satisfy Equation (1).

$$[\{(Max\text{-}Min)/mean\}\times100]<(5+0.5\times D)\ldots(1)$$

    (D: distance ($\mu$m) between the surface in the vicinity of the outermost surface and the surface in the vicinity of the first surface,
    mean: average value (cm$^{-3}$) of the density of the $Z_{1/2}$ centers at 10 locations)

6. A method for manufacturing a SiC epitaxial wafer, comprising:

    a formation step of forming a SiC epitaxial layer on a first surface of a SiC substrate by a chemical vapor deposition method using a growth apparatus having a gas supply port for supplying a Si-based gas and a C-based gas and a gas discharge port,
    wherein the formation step includes an adjustment step of analyzing a gas discharged from the gas discharge port by quadrupole mass spectrometry, increasing an amount of supply of the C-based gas relative to the Si-based gas when an analyzed C/Si ratio is lower than a target value, and decreasing the amount of supply of the C-based gas relative to the Si-based gas when the analyzed C/Si ratio is higher than the target value.

7. The method for manufacturing a SiC epitaxial wafer of claim 6, further comprising a test step, and a feedback step before the formation step,
    wherein the test step includes:

    a preliminary measurement step of measuring a weight and a surface area of a by-product in a growth apparatus;
    a first formation step of forming a SiC epitaxial layer on a first surface of a test SiC substrate while analyzing a gas discharged from a gas discharge port by quadrupole mass spectrometry using the growth apparatus in which the preliminary measurement step has been performed;
    an analysis step of analyzing a uniformity of a density of a $Z_{1/2}$ center in a depth direction in the SiC epitaxial layer of the SiC epitaxial wafer formed in the first formation step; and
    a measurement step of measuring the weight and the surface area of the by-product in the growth apparatus after the first forming step, and
    the feedback step sets the target value based on a result of the test step.

8. The method for manufacturing a SiC epitaxial wafer of claim 7, wherein the analysis step includes:

a film thickness measurement step of measuring a film thickness of a SiC epitaxial layer on a SiC epitaxial wafer having a center (0,0) in a plan view and a radius R;

a first evaluation step of evaluating the density of the $Z_{1/2}$ centers at five locations of (0,0), ($\pm$R/2,0), and (0,$\pm$R/2) from an outermost surface of the SiC epitaxial wafer by a deep level transient spectroscopy (DLTS) method;

a removal step of removing a predetermined thickness of the SiC epitaxial layer; and

a second evaluation step of evaluating, after the removal step, the density of the $Z_{1/2}$ centers at five positions of (0, 0), ($\pm$R/2, 0), and (0, $\pm$R/2) from the outermost surface of the SiC epitaxial wafer by the DLTS method, and the uniformity of the density of the $Z_{1/2}$ centers in the depth direction, which is obtained by dividing a difference between the density of the $Z_{1/2}$ centers in the first evaluation step and the density of the $Z_{1/2}$ centers in the second evaluation step at the same location in a plan view by a predetermined thickness, is analyzed.

9. A SiC device comprising:

a SiC substrate; and

a SiC epitaxial layer formed on a first surface of the SiC substrate, wherein a uniformity of a $Z_{1/2}$ center density in a depth direction in the SiC epitaxial layer is less than 0.5 (%/$\mu$m).

FIG. 1

FIG. 2

## FIG. 3

## FIG. 4

FIG. 5

(a)                                    (b)

EP 4 717 802 A1

# FIG. 6

FIG. 7

(a)

(b)

EXHAUST GAS QMS (C/Si)

AMOUNT OF C-BASED GAS

TARGET VALUE OF
EXHAUST GAS QMS (C/Si)

GROWTH TIME

FIG. 8

(a)

(b)

DENSITY OF $Z_{1/2}$ CENTER

GROWTH TIME

TARGET VALUE OF
EXHAUST GAS QMS (C/Si)

GROWTH TIME

## FIG. 9

(a)

NECESSARY AMOUNT OF CORRECTION (p)

DEPOSITION AREA
(=WEIGHT × SPECIFIC SURFACE AREA)

(b)

TARGET VALUE OF EXHAUST GAS QMS (C/Si)

↓ p

GROWTH TIME

## FIG. 10

10

200

201

Y

Z ⊙ → X

OF

## FIG. 11

in-situ control

## FIG. 12

without in-situ control

Europäisches
Patentamt

European
Patent Office

Office européen
des brevets

# EUROPEAN SEARCH REPORT

**Application Number**

EP 25 20 4567

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TETSUYA MIYAZAWA ET AL: "Growth of 4H-SiC Epilayers and $Z_{1/2}$ Center Elimination", MATERIALS SCIENCE FORUM, vol. 717-720, 1 May 2012 (2012-05-01), pages 81-86, XP055095356, DOI: 10.4028/www.scientific.net/MSF.717-720.81 | 1-3,9 | INV. C30B25/16 C30B29/36 |
| A | * "Experimental"; figure 4 * | 4-8 | |
| X | DONG PENG ET AL: "Electron Radiation Effects on the 4H-SiC PiN Diodes Characteristics: An Insight From Point Defects to Electrical Degradation", IEEE ACCESS, vol. 7, 25 November 2019 (2019-11-25), pages 170385-170391, XP011753458, DOI: 10.1109/ACCESS.2019.2955385 [retrieved on 2019-12-03] | 1-3,9 | |
| A | * figure 7 * | 4-8 | **TECHNICAL FIELDS SEARCHED (IPC)** |
| X | SAITO EIJI ET AL: "Control of carrier lifetime of thick n-type 4H-SiC epilayers by high-temperature Ar annealing", APPLIED PHYSICS EXPRESS, vol. 9, no. 6, 23 May 2016 (2016-05-23), page 061303, XP093357447, ISSN: 1882-0778, DOI: 10.7567/APEX.9.061303 Retrieved from the Internet: URL:https://iopscience.iop.org/article/10.7567/APEX.9.061303/pdf> | 1-3,9 | C30B |
| A | * figure 1(a) * | 4-8 | |

-/--

The present search report has been drawn up for all claims

| Place of search | Date of completion of the search | Examiner |
|---|---|---|
| The Hague | 12 February 2026 | Leibold, Joachim |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

| | Europäisches Patentamt European Patent Office Office européen des brevets | **EUROPEAN SEARCH REPORT** | **Application Number** EP 25 20 4567 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/024719 A1 (VANMIL BRENDA L [US] ET AL) 4 February 2010 (2010-02-04) | 1,4-9 | |
| A | * paragraphs [0002], [0020], [0021], [0024], [0033], [0035], [0094], [0099], [0001]; figure 1 * ----- | 2,3 | |
| A | HABUKA HITOSHI ET AL: "By-Product Formation in a Trichlorosilane-Hydrogen System for Silicon Film Deposition", ECS JOURNAL OF SOLID STATE SCIENCE AND TECHNOLOGY, vol. 4, no. 2, 13 November 2014 (2014-11-13), pages P16-P19, XP055862391, US ISSN: 2162-8769, DOI: 10.1149/2.0031502jss Retrieved from the Internet: URL:https://iopscience.iop.org/article/10.1149/2.0031502jss/pdf> * the whole document * ----- | 1-9 | |
| A | US 2022/146564 A1 (MURATA KOICHI [JP] ET AL) 12 May 2022 (2022-05-12) * the whole document * ----- | 1-9 | TECHNICAL FIELDS SEARCHED (IPC) |

The present search report has been drawn up for all claims

| Place of search | Date of completion of the search | Examiner |
|---|---|---|
| The Hague | 12 February 2026 | Leibold, Joachim |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

## ANNEX TO THE EUROPEAN SEARCH REPORT
## ON EUROPEAN PATENT APPLICATION NO.

EP 25 20 4567

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2026

| Patent document cited in search report | Publication date | Patent family member(s) | | Publication date |
|---|---|---|---|---|
| US 2010024719 A1 | 04-02-2010 | NONE | | |
| US 2022146564 A1 | 12-05-2022 | JP | 7588495 B2 | 22-11-2024 |
| | | JP | 2022075127 A | 18-05-2022 |
| | | US | 2022146564 A1 | 12-05-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016132604 A

**Non-patent literature cited in the description**

- *J. Appl. Phys.*, 2013, vol. 113, 083714